(19) Europäisches Patentamt
European Patent Office
Office européen des brevets

(11) **EP 2 792 650 A1**

(12) **DEMANDE DE BREVET EUROPEEN**

(43) Date de publication:
**22.10.2014 Bulletin 2014/43**

(21) Numéro de dépôt: **14172252.0**

(22) Date de dépôt: **04.01.2008**

(51) Int Cl.:
**C03C 17/09** *(2006.01)*   **C03C 17/245** *(2006.01)*
**C03C 17/36** *(2006.01)*   **C03C 23/00** *(2006.01)*
**C30B 1/08** *(2006.01)*   **C23C 14/58** *(2006.01)*
**H01L 31/0224** *(2006.01)*   **H01L 31/18** *(2006.01)*

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **05.01.2007 FR 0752550**

(62) Numéro(s) de document de la (des) demande(s) initiale(s) en application de l'article 76 CBE:
**08750464.3 / 2 118 031**

(71) Demandeur: **Saint-Gobain Glass France**
**92400 Courbevoie (FR)**

(72) Inventeurs:
• **Nadaud, Nicolas**
**75013 PARIS (FR)**
• **Kharchenko, Andriy**
**91120 PALAISEAU (FR)**
• **Billert, Ulrich**
**92380 GARCHES (FR)**
• **Gy, René**
**93140 BONDY (FR)**

(74) Mandataire: **Teyssedre, Laurent**
**Saint-Gobain Recherche**
**Département Propriété Industrielle**
**39 Quai Lucien Lefranc**
**93300 Aubervilliers Cedex (FR)**

Remarques:
Cette demande a été déposée le 13-06-2014 comme demande divisionnaire de la demande mentionnée sous le code INID 62.

(54) **Procédé de dépôt de couche mince et produit obtenu**

(57)   L'invention a pour objet un matériau qui est un substrat en verre non-trempé revêtu sur sa première face d'un empilement de couches minces comprenant au moins une couche d'argent d'épaisseur e (exprimée en nm), susceptible d'être obtenu par un procédé de traitement dans lequel on porte chaque point de ladite au moins une couche mince d'argent à une température d'au moins 300°C en maintenant une température inférieure ou égale à 150°C en tout point de la face dudit substrat opposée à ladite première face, de manière à augmenter le taux de cristallisation de ladite couche mince d'argent en la conservant continue et sans étape de fusion de ladite couche mince d'argent, ledit matériau étant tel que l'empilement présente une résistance carrée $R_c$ (exprimée en ohm) répondant à la formule :

$$R_c \times e^2 - 120 < 25 \times e.$$

**EP 2 792 650 A1**

**Description**

L'invention se rapporte au domaine des couches minces inorganiques, notamment déposées sur des substrats en verre. Elle concerne plus particulièrement un procédé de cristallisation au moins partielle desdites couches minces et certains produits obtenus à l'aide de ce procédé.

De nombreuses couches minces sont déposées sur des substrats, notamment en verre plat ou faiblement bombé, afin de conférer aux matériaux obtenus des propriétés particulières : propriétés optiques, par exemple de réflexion ou d'absorption de rayonnements d'un domaine de longueurs d'onde données, propriétés de conduction électrique particulière, ou encore propriétés liées à la facilité de nettoyage ou à la possibilité pour le matériau de s'auto-nettoyer.

Ces couches minces sont le plus souvent à base de composés inorganiques : oxydes, nitrures, ou encore métaux. Leur épaisseur varie généralement de quelques nanomètres à quelques centaines de nanomètres, d'où leur qualificatif de « minces ».

A titre d'exemples, on peut citer les couches minces à base d'oxydes mixtes d'étain et d'indium (appelées « ITO »), à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé au fluor et/ou à l'antimoine. Ces différentes couches ont la particularité d'être des couches transparentes et néanmoins conductrices ou semi-conductrices, et sont employées dans de nombreux systèmes où ces deux propriétés sont nécessaires : écrans à cristaux liquides (LCD), capteurs solaires ou photovoltaïques, dispositifs électrochromes ou électroluminescents...

On peut également citer les couches minces à base d'argent métallique, ou encore de molybdène ou de niobium métalliques, lesquelles ont des propriétés de conduction électrique et de réflexion des rayonnements infrarouges, d'où leur utilisation dans des vitrages à contrôle solaire, notamment anti-solaires (visant à diminuer la quantité d'énergie solaire entrante) ou à faible émissivité (visant à diminuer la quantité d'énergie dissipée vers l'extérieur d'un bâtiment ou d'un véhicule).

On peut encore citer les couches minces à base d'oxyde de titane, lesquelles ont la particularité d'être autonettoyantes, en facilitant la dégradation des composés organiques sous l'action de rayonnements ultraviolets et l'élimination des salissures minérales (poussières) sous l'action d'un ruissellement d'eau.

Les différentes couches citées présentent la particularité commune de voir certaines de leurs propriétés améliorées lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X), voire dans certains cas à favoriser une forme cristallographique particulière.

Dans le cas de l'oxyde de titane, il est connu que l'oxyde de titane cristallisé sous la forme anatase est bien plus efficace en terme de dégradation des composés organiques que l'oxyde de titane amorphe ou cristallisé sous la forme rutile ou brookite.

Il est également connu que les couches d'argent présentant un taux de cristallisation élevé et par conséquent une faible teneur résiduelle en argent amorphe présentent une émissivité et une résistivité plus basses que des couches d'argent majoritairement amorphes. La conductivité électrique et les propriétés de faible émissivité de ces couches sont ainsi améliorées.

De même, les couches transparentes conductrices précitées, notamment celles à base d'oxyde de zinc dopé ou les couches d'oxyde d'indium dopé à l'étain présentent une conductivité électrique d'autant plus forte que leur taux de cristallisation est élevé.

Un procédé couramment employé à l'échelle industrielle pour le dépôt de couches minces, notamment sur substrat verrier, est le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. Il est ainsi connu de déposer, par procédé magnétron du type réactif, des couches d'oxyde de titane en employant une cible en titane métallique et un gaz plasmagène à base d'oxygène. L'avantage majeur de ce procédé réside dans la possibilité de déposer sur une même ligne un empilement très complexe de couches en faisant successivement défiler le substrat sous différentes cibles, ce généralement dans un seul et même dispositif.

Lors de la mise en oeuvre industrielle du procédé magnétron, le substrat reste à température ambiante ou subit une élévation de température modérée (moins de 80°C), particulièrement lorsque la vitesse de défilement du substrat est élevée (ce qui est généralement recherché pour des raisons économiques). Ce qui peut paraître un avantage constitue toutefois un inconvénient dans le cas des couches précitées, car les faibles températures impliquées ne permettent généralement pas une croissance cristalline suffisante. C'est le cas tout particulièrement pour des couches minces de faible épaisseur et/ou des couches constituées de matériaux dont le point de fusion est très élevé. Les couches obtenues selon ce procédé sont donc majoritairement voire totalement amorphes ou nano-cristallisées (la taille moyenne des grains cristallins étant inférieure à quelques nanomètres), et des traitements thermiques se révèlent nécessaires pour obtenir le taux de cristallisation souhaité ou la taille de grains désirée.

Des traitements thermiques possibles consistent à réchauffer le substrat soit pendant le dépôt, soit à l'issue du dépôt, en sortie de ligne magnétron. Le plus généralement, des températures d'au moins 200°C ou 300°C sont nécessaires. La cristallisation est en effet d'autant meilleure et la taille des grains est d'autant plus grande que la température du substrat est proche de la température de fusion du matériau constituant le film mince.

Le chauffage du substrat dans les lignes magnétron industrielles (pendant le dépôt) s'est toutefois révélé malaisé à mettre en oeuvre, en particulier car les transferts de chaleur sous vide, nécessairement de nature radiative, sont difficiles à maîtriser et impliquent un coût élevé dans le cas des substrats de grande taille, de plusieurs mètres de largeur. Dans le cas de substrats de verre de faible épaisseur, ce type de traitement implique souvent des risques de casse élevés.

Le chauffage du substrat revêtu à l'issue du dépôt, par exemple en plaçant le substrat dans un four ou une étuve ou en soumettant le substrat au rayonnement infrarouge issu de dispositifs de chauffage conventionnels tels que des lampes infrarouge, présente également des inconvénients car ces différents procédés contribuent à chauffer sans discernement le substrat et la couche mince. Le chauffage du substrat à des températures supérieures à 150°C est susceptible de générer des casses dans le cas de substrats de grande taille (plusieurs mètres de large) car il est impossible d'assurer une température identique sur toute la largeur du substrat. Le chauffage des substrats ralentit également l'ensemble du procédé, car il est nécessaire d'attendre leur refroidissement complet avant d'envisager leur découpe ou leur stockage, qui a généralement lieu en empilant les substrats les uns sur les autres. Un refroidissement très contrôlé est en outre indispensable pour éviter la génération de contraintes au sein du verre, et donc la possibilité de casses. Un tel refroidissement très contrôlé étant très coûteux, le recuit n'est généralement pas suffisamment contrôlé pour éliminer les contraintes thermiques au sein du verre, ce qui génère un nombre accru de casses en ligne. Le recuit présente en outre l'inconvénient de rendre la découpe du verre plus difficile, les fissures ayant une tendance moins forte à se propager linéairement.

Le chauffage des substrats a lieu dans le cas où les vitrages sont bombés et/ou trempés, car un réchauffage du verre au-delà de sa température de ramollissement (généralement à plus de 600°C, voire 700°C pendant quelques minutes) est effectué. La trempe ou le bombage permet donc d'obtenir le résultat souhaité de cristallisation des couches minces. Il serait toutefois coûteux de soumettre à de tels traitements tous les vitrages dans le seul but d'améliorer la cristallisation des couches. En outre, les vitrages trempés ne peuvent plus être découpés, et certains empilements de couches minces ne supportent pas les températures élevées subies lors de la trempe du verre.

L'invention a pour but de proposer un procédé permettant d'améliorer les propriétés de cristallisation de nombreuses couches minces mais ne présentant pas les inconvénients susmentionnés.

A cet effet, l'invention a pour objet un procédé de traitement d'au moins une couche mince continue déposée sur une première face d'un substrat, caractérisé en ce que l'on porte chaque point de ladite au moins une couche mince à une température d'au moins 300°C en maintenant une température inférieure ou égale à 150°C en tout point de la face dudit substrat opposée à ladite première face, de manière à augmenter le taux de cristallisation de ladite couche mince en la conservant continue et sans étape de fusion de ladite couche mince.

Par « couche mince continue », on entend au sens de la présente invention que la couche recouvre sensiblement la totalité du substrat ou, dans le cas d'un empilement, la totalité de la couche sous-jacente. Il est important que le caractère continu de la couche mince (et donc ses propriétés avantageuses) soit préservé par le traitement selon l'invention.

Par « point de la couche », on entend une zone de la couche subissant le traitement à un instant donné. Selon l'invention, la totalité de la couche (donc chaque point) est portée à une température d'au moins 300°C, mais chaque point de la couche n'est pas nécessairement traité simultanément. La couche peut être traitée au même instant dans son ensemble, chaque point de la couche étant simultanément porté à une température d'au moins 300°C. La couche peut alternativement être traitée de manière à ce que les différents points de la couche ou des ensembles de points soient successivement portés à une température d'au moins 300°C, ce deuxième mode étant plus souvent employé dans le cas d'une mise en oeuvre continue à l'échelle industrielle.

Le procédé selon l'invention permet d'apporter une énergie suffisante pour favoriser la cristallisation de la couche mince, par un mécanisme physico-chimique de croissance cristalline autour de germes déjà présents dans la couche, en restant en phase solide. Le procédé selon l'invention ne met pas en oeuvre de mécanisme de cristallisation par refroidissement à partir d'un matériau fondu, d'une part car cela nécessiterait de porter la couche mince à des températures extrêmement élevées pour obtenir sa fusion, et d'autre part car cela serait susceptible de modifier les épaisseurs et/ou les indices de réfraction des couches, et donc leurs propriétés. Cela modifierait notamment leur aspect optique en générant des inhomogénéités détectables à l'oeil.

Le procédé selon l'invention présente l'avantage de ne chauffer que la couche mince (ou les couches minces dans le cas d'un empilement), sans échauffement significatif de la totalité du substrat. Il n'est ainsi plus nécessaire de procéder à un refroidissement lent et contrôlé du substrat avant la découpe ou le stockage du verre. Ce procédé rend également possible l'intégration d'un dispositif de chauffage sur les lignes de production continue existantes, plus particulièrement dans l'espace situé entre la sortie de l'enceinte de dépôt sous vide de la ligne magnétron et le dispositif de stockage du verre par empilage. Il est également possible dans certains cas de réaliser le traitement selon l'invention au sein même de l'enceinte de dépôt sous vide.

Dans une mise en oeuvre industrielle intégrée à une ligne magnétron, le procédé est généralement continu au sens où le substrat est en défilement, donc subit un mouvement linéaire dans une direction X. Chaque point de la couche mince est alors de préférence traité selon l'un des modes suivants : soit les moyens de chauffage sont fixes et l'on peut traiter simultanément un ensemble de points formant une ligne selon une direction Y perpendiculaire à la direction X, soit les moyens de chauffage sont mobiles selon la direction Y et l'on traite successivement chaque point. Le procédé selon l'invention peut être mis en oeuvre sur un substrat placé aussi bien horizontalement que verticalement. Il peut également être mis en oeuvre sur un substrat pourvu de couches minces sur ses deux faces, au moins une couche d'une des faces ou de chaque face étant traitée selon l'invention. Dans le cas où des couches minces déposées sur les deux faces du substrat sont traitées selon l'invention, il est possible de traiter lesdites couches minces de chaque face soit simultanément, soit successivement, par des techniques identiques ou distinctes, en particulier selon que la nature des couches traitées est identique ou distincte. Le cas où le traitement selon l'invention est réalisé simultanément sur les deux faces du substrat est donc bien compris dans la portée de l'invention.

Il n'est pas physiquement possible de chauffer la couche sans chauffer le substrat, car l'élévation de température au sein de la couche entraîne nécessairement, par des mécanismes de conduction thermique, un chauffage de la zone du substrat la plus proche de la couche, et donc un gradient thermique élevé dans l'épaisseur du substrat. De tels gradients thermiques élevés, parfois appelés chocs thermiques, sont connus pour générer systématiquement des casses dans le cas des verres silico-sodo-calciques couramment employés dans l'industrie du verre plat. Ces casses, qui ont pour origine le différentiel de dilatation thermique entre les différentes zones du verre soumises à des températures différentes, se produisent plus aisément dans le cas des verres silico-sodo-calciques car leur coefficient de dilatation est assez élevé. Elles se produisent également plus aisément dans le cas de substrats de grande dimension (d'au moins 1 m, voire 2 ou même 3 m de large) car il est plus délicat d'assurer une homogénéité de température élevée pour de grands substrats.

Les inventeurs ont toutefois mis en évidence qu'un traitement thermique ne mettant en oeuvre qu'un chauffage modéré et contrôlé d'une zone limitée du substrat permettait de s'affranchir de ce problème de casse, jusqu'alors jugé inévitable. Il est donc indispensable pour la mise en oeuvre de la présente invention que la température de la face du substrat opposée à la face portant la couche mince traitée ne soit pas supérieure à 150°C. Cette caractéristique est obtenue en choisissant un mode de chauffage spécialement adapté au chauffage de la couche mince et non du substrat et en contrôlant le temps ou l'intensité de chauffage et/ou d'autres paramètres en fonction du mode de chauffage employé, comme décrit plus en détail dans la suite du texte.

Une caractéristique commune à tous les modes de chauffage utilisables selon l'invention réside dans le fait qu'ils permettent de générer une puissance par unité de surface extrêmement élevée, qui ne peut toutefois pas être quantifiée de manière absolue car elle dépend de nombreux facteurs parmi lesquels la nature et l'épaisseur de la couche mince. Cette forte puissance par unité de surface permet d'atteindre au niveau de la couche la température souhaitée extrêmement rapidement (en général en un temps inférieur ou égal à 1 seconde) et par conséquent de limiter d'autant la durée du traitement, la chaleur générée n'ayant alors pas le temps de diffuser au sein du substrat. Chaque point de la couche mince est soumis au traitement selon l'invention (c'est-à-dire porté à une température supérieure ou égale à 300°C) pour une durée généralement inférieure ou égale à 1 seconde, voire 0,5 seconde. A l'inverse, les lampes infrarouge classiquement utilisées ne permettant pas d'atteindre ces fortes puissances par unité de surface, le temps de traitement doit être plus long pour atteindre les températures désirées (souvent plusieurs secondes), et le substrat est alors nécessairement porté à des températures élevées par diffusion de la chaleur, ce même si la longueur d'ondes du rayonnement est adaptée pour n'être absorbée que par la couche mince et non par le substrat.

Afin de limiter au maximum le nombre de casses pour les substrats les plus grands (par exemple de 6 m de long sur 3 m de large), on maintient de préférence tout au long du traitement une température inférieure ou égale à 100°C, notamment 50°C, en tout point de la face du substrat opposée à la face sur laquelle est déposée la couche mince.

Un autre avantage de l'invention réside dans le fait que le procédé fait subir l'équivalent d'une trempe à la couche mince ou à l'empilement de couches minces. Il arrive que certains empilements de couches minces voient leurs propriétés optiques (coordonnées colorimétriques, transmission lumineuse ou énergétique) modifiées lorsque le verre est trempé. Le procédé selon l'invention permet alors d'obtenir un verre non trempé (donc ne présentant pas en son sein un profil de contraintes spécifique au verre trempé, ce qui le rend découpable) mais présentant sensiblement les mêmes propriétés optiques que s'il avait été trempé.

Le taux de cristallisation obtenu à l'aide du procédé selon l'invention est de préférence supérieur ou égal à 20% ou 50 %, notamment 70% et même 90%. Ce taux de cristallisation, défini comme étant la masse de matériau cristallisé sur la masse totale de matériau, peut être évalué par diffraction des rayons X en utilisant la méthode de Rietveld. Du fait d'un mécanisme de cristallisation par croissance de grains cristallins à partir de germes ou nuclei, l'augmentation du taux de cristallisation s'accompagne généralement d'une augmentation de la taille des grains cristallisés ou des domaines cohérents de diffraction mesurés par diffraction des rayons X.

Le substrat est de préférence transparent, en verre, notamment silico-sodo-calcique. Il peut également être en matière plastique, tel que le polycarbonate ou le polyméthacrylate de méthyle. Il présente avantageusement au moins une dimension supérieure ou égale à 1 m, voire 2 m et même 3 m. L'épaisseur du substrat varie généralement entre 0,5 mm et 19 mm, le procédé selon l'invention étant particulièrement avantageux pour les substrats les plus minces, dont l'épaisseur est inférieure ou égale à 4 mm, voire 2 mm.

La couche mince est de préférence une couche dont au moins une propriété est améliorée lorsque le taux de cristallisation de ladite couche augmente. Pour les raisons évoquées *supra,* et liées à la corrélation entre propriétés et taux de cristallisation, la couche mince est de préférence à base d'un métal, oxyde, nitrure, ou mélange d'oxydes choisi parmi l'argent, le molybdène, le niobium, l'oxyde de titane, les oxydes mixtes d'indium et de zinc ou d'étain, l'oxyde de zinc dopé à l'aluminium ou au gallium, les nitrures de titane, d'aluminium ou de zirconium, l'oxyde de titane dopé au niobium, le stannate de cadmium et/ou d'étain, l'oxyde d'étain dopé au fluor et/ou à l'antimoine. Elle est même de préférence constituée d'un tel métal, oxyde, nitrure ou mélange d'oxydes. L'épaisseur de la couche mince est de préférence comprise entre 2 et 500 nm.

La plupart des couches minces susmentionnées ont la particularité d'être globalement transparentes au rayonnement UV-visible (l'absorption étant inférieure à 50% dans le domaine du visible). Leur spectre d'absorption étant peu différent de celui du substrat (notamment dans le cas où ce dernier est en verre), il est d'autant difficile de chauffer spécifiquement la couche et non le substrat. D'autres couches comme le silicium présentent une forte absorption dans le visible et le proche infrarouge, ce qui facilite leur chauffage sélectif, par exemple dans le cas de la transformation du silicium amorphe en silicium polycristallin.

La couche mince traitée selon l'invention peut être la seule couche mince déposée sur le substrat. Elle peut également être comprise dans un empilement de couches minces comprenant des couches minces, généralement choisies parmi des oxydes, des nitrures ou des métaux. La couche mince peut également être en elle-même un empilement de couches minces. Dans le cas où la couche mince traitée est comprise dans un empilement de couches minces, le procédé selon l'invention peut améliorer les propriétés de cristallisation d'une ou de plusieurs couches minces de l'empilement.

Lorsque la couche mince est une couche d'argent ou à base d'argent, elle est de préférence comprise dans un empilement de couches, notamment afin d'éviter son oxydation. Dans le cas des vitrages à contrôle solaire ou à faible émissivité, la couche mince à base d'argent est généralement disposée entre deux couches minces diélectriques à base d'oxyde ou de nitrure. Peuvent être également disposées sous la couche d'argent une couche très fine destinée à favoriser le mouillage et la nucléation de l'argent (par exemple en oxyde de zinc ZnO) et sur la couche d'argent une seconde couche très fine (sacrificielle, par exemple en titane) destinée à protéger la couche d'argent au cas où le dépôt de la couche subséquente est réalisé dans une atmosphère oxydante ou en cas de traitements thermiques conduisant à une migration d'oxygène au sein de l'empilement. Les empilements peuvent également comprendre plusieurs couches d'argent, chacune de ces couches étant généralement affectée par la mise en oeuvre du procédé selon l'invention. Dans le cas où l'empilement comprend une couche d'oxyde de zinc, le traitement de la couche d'argent s'accompagne aussi généralement d'une augmentation du taux de cristallisation de l'oxyde de zinc.

Lorsque la couche mince est une couche transparente conductrice, par exemple à base d'oxyde de zinc dopé au gallium et/ou à l'aluminium, elle peut être comprise dans un empilement de couches comprenant au moins une sous-couche faisant office de barrière à la migration des alcalins et/ou au moins une surcouche faisant office de barrière à l'oxydation. Ce type d'empilements est par exemple décrit dans la demande WO 2007/018951 incorporée par référence dans la présente demande. Le traitement selon l'invention permet toutefois de s'affranchir avantageusement de ce type de sous-couches ou surcouches, car la rapidité du chauffage engendre très peu de migration d'alcalins ou d'oxygène, comparativement à un recuit ou une trempe. Cela est d'autant plus avantageux dans le cas où la couche conductrice doit servir d'électrode et doit donc être en contact électrique direct avec d'autres couches fonctionnelles (cas par exemple des applications photovoltaïques ou OLED) : dans le cas d'une trempe ou d'un recuit, la surcouche de protection face à l'oxydation est nécessaire pendant le traitement et doit ensuite être éliminée. Grâce au procédé selon l'invention, il est possible de se passer de cette surcouche.

La couche à base d'oxyde de titane est de préférence une couche en oxyde de titane (éventuellement dopé). L'intégralité de la surface de cette couche est de préférence en contact avec l'extérieur de manière à ce que l'oxyde de titane puisse pleinement jouer sa fonction auto-nettoyante. Afin d'améliorer encore la cristallisation de ces couches, il est possible de prévoir sous la couche à base d'oxyde de titane une sous-couche ayant pour effet de favoriser la croissance cristalline de l'oxyde de titane, notamment sous forme anatase. Il peut notamment s'agir d'une sous-couche en $ZrO_2$, telle que décrite dans la demande WO 02/40417, ou encore une sous-couche favorisant la croissance hétéro-épitaxiale de l'oxyde de titane sous forme anatase, telle que décrite par exemple dans la demande WO2005/040058 incorporée à titre de référence, notamment une couche en $BaTiO_3$ ou $SrTiO_3$.

**EP 2 792 650 A1**

La couche mince avant traitement selon l'invention peut être obtenue par tout type de procédé, en particulier des procédés générant des couches majoritairement amorphes ou nano-cristallisées, tels que le procédé magnétron, le procédé de dépôt chimique en phase vapeur assisté par plasma (PECVD), le procédé d'évaporation sous vide, ou le procédé sol-gel. Elle est toutefois de préférence une couche « sèche », ne contenant pas de solvant aqueux ou organique, en opposition avec une couche « humide », par exemple obtenue par le procédé sol-gel. Elle est même de préférence obtenue par pulvérisation cathodique, notamment assistée par champ magnétique (procédé magnétron). Dans le cas d'une couche obtenue par le procédé sol-gel, des précurseurs en solution (sol) sont déposés sur le substrat, la couche obtenue devant ensuite être séchée et recuite pour éliminer toute trace de solvant. Dans ce cas, l'énergie apportée par le chauffage sert alors majoritairement à éliminer ce solvant, sans affecter nécessairement les propriétés de cristallisation de la couche, et il est par conséquent plus difficile d'améliorer lesdites propriétés en un temps suffisamment court pour ne pas chauffer également le substrat.

Pour plus de simplicité, le chauffage de la couche se fait de préférence sous air et/ou à pression atmosphérique. Certains modes de chauffage sont toutefois compatibles avec le vide, et il peut être avantageux de procéder au chauffage de la couche au sein même de l'enceinte de dépôt sous vide, par exemple avant un dépôt subséquent.

Différents moyens de chauffage permettent de mettre en oeuvre le procédé selon l'invention, en permettant la génération d'une puissance par unité de surface très élevée. Les paramètres du chauffage tels que la puissance des moyens de chauffage ou le temps de chauffage sont à adapter au cas par cas par l'homme du métier en fonction de divers paramètres tels que la nature du procédé de chauffage, l'épaisseur ou la nature de la couche, la taille et l'épaisseur des substrats à traiter etc.

Lorsque la couche mince est électroconductrice (cas de l'argent par exemple), le chauffage de la couche mince peut être réalisé par induction.

Le chauffage par induction de pièces métalliques est un procédé bien connu pour atteindre de façon rapide et contrôlée des températures élevées au sein de pièces massives conductrices (renforcement des aciers, fusion de zone du silicium...). Les principales applications concernent les domaines de l'agroalimentaire (chauffage de cuves, cuisson de produits plats sur bandes métalliques, cuisson-extrusion) et de la fabrication des métaux (fusion, réchauffage avant formage, traitement thermique dans la masse, traitement thermique superficiel, traitement des revêtements, soudage, brasage).

Un courant alternatif parcourant un bobinage (appelé solénoïde ou spire) génère à l'intérieur de celui-ci un champ magnétique oscillant à la même fréquence. Si une pièce conductrice de l'électricité est placée à l'intérieur de la bobine (ou solénoïde), des courants induits par le champ magnétique s'y développent et chauffent la pièce par effet Joule.

Les courants apparaissent à la surface de la pièce à chauffer. Une profondeur caractéristique appelée épaisseur de peau peut être définie, donnant en première approche l'épaisseur de la couche de courant. L'épaisseur de peau des courants dépend de la nature du métal chauffé et décroît quand la fréquence du courant augmente.

Dans le cas du chauffage d'un substrat isolant recouvert d'une couche conductrice, il est préférable d'utiliser une polarisation à fréquence élevée afin de concentrer l'influence de l'inducteur sur la partie superficielle du matériau. La fréquence est de préférence comprise entre 500 kHz et 5 MHz, notamment entre 1 MHz et 3 MHz. Un inducteur spécialement adapté au traitement de surfaces planes est de préférence employé.

L'induction n'est pas préférée lorsque la couche mince présente une épaisseur de moins de 20 nm, voire moins de 10 nm. Pour ces couches particulièrement minces, une très haute fréquence est nécessaire, et le volume de la couche étant très faible, l'efficacité du traitement est compromise.

Lorsque la couche mince absorbe au moins une partie du rayonnement infrarouge, le chauffage de la couche mince peut être réalisé à l'aide d'un rayonnement dont la longueur d'onde est comprise dans ladite partie du rayonnement infrarouge absorbée par ladite couche. Afin de limiter au maximum les apports de chaleur au substrat, la longueur d'onde du rayonnement choisi n'est de préférence pas comprise dans la partie du rayonnement infrarouge absorbée par le substrat. Pour les raisons susmentionnées, le rayonnement doit se caractériser par une puissance par unité de surface élevée. Pour cette raison, le chauffage de la couche mince est de préférence réalisé à l'aide d'un laser émettant un rayonnement infrarouge. Des systèmes de lampes infrarouges associées à un dispositif de focalisation permettant d'atteindre de fortes puissances par unité de surface sont également utilisables.

Dans le cas d'une couche à base d'oxyde de titane, il est préférable d'employer un laser émettant un rayonnement dont la longueur d'ondes est comprise entre 5 et 15 micromètres, par exemple un laser à $CO_2$ émettant un rayonnement dont la longueur d'onde est de 10,6 micromètres. Dans le cas d'une couche à base d'argent, il est préférable d'employer un laser émettant un rayonnement dont la longueur d'ondes est comprise entre 0,5 et 5 micromètres. Un laser YAG (grenat d'aluminium et d'yttrium $Y_2Al_{15}O_2$) dopé au néodyme, émettant, en mode continu ou pulsé, un rayonnement d'environ 1 micromètre de longueur d'onde, s'est révélé particulièrement bien adapté, notamment lorsque le substrat n'absorbe pas dans ce domaine de longueurs d'ondes, ce qui est le cas pour des verres clairs, dont la teneur pondérale en oxyde de fer est de 0,1% ou moins.

L'utilisation de lasers à excimère, émettant un rayonnement dans le domaine de l'ultraviolet, est également possible pour des couches absorbant un tel rayonnement.

Pour une simplicité de mise en oeuvre accrue, les lasers employés dans le cadre de l'invention peuvent être fibrés, ce qui signifie que le rayonnement laser est injecté dans un fibre optique puis délivré près de la surface à traiter par une tête de focalisation. Le laser peut également être à fibre, au sens où le milieu d'amplification est lui-même une fibre optique.

Les lasers ne pouvant irradier qu'une faible surface (typiquement de l'ordre d'une fraction de mm$^2$ à quelque centaines de mm$^2$), il est nécessaire, afin de traiter toute la surface, de prévoir un système de déplacement du faisceau laser dans le plan du substrat ou un système formant un faisceau laser en ligne irradiant simultanément toute la largeur du substrat, et sous laquelle ce dernier vient défiler.

Le chauffage de la couche mince peut encore être réalisé par des techniques de projection thermique, notamment par une technique de projection par torche plasma (plasma spray).

Un plasma est un gaz ionisé généralement obtenu en soumettant un gaz dit « plasmagène » à une excitation telle qu'un fort champ électrique continu ou alternatif (par exemple un arc électrique). Sous l'action de cette excitation, des électrons sont arrachés aux atomes du gaz et les charges ainsi créées migrent vers les électrodes de charge opposée. Ces charges excitent ensuite d'autres atomes du gaz par collision, créant par effet d'avalanche une décharge homogène ou microfilamentaire ou encore un arc. Les plasmas peuvent être « chauds » (le gaz est alors entièrement ionisé et la température du plasma est de l'ordre de $10^6$°C), ou « thermiques » (le gaz est presque entièrement ionisé et la température du plasma est de l'ordre de $10^4$°C, cas par exemple des arcs électriques). Les plasmas contiennent beaucoup d'espèces actives, c'est-à-dire susceptibles d'interagir avec la matière, dont les ions, les électrons ou les radicaux libres. Dans le cas d'une torche plasma, un gaz est insufflé à travers un arc électrique, et le plasma thermique formé est soufflé vers le substrat à traiter. La torche plasma est couramment employée pour déposer des couches minces sur des substrats divers en ajoutant dans le plasma des précurseurs sous forme de poudres.

Dans le cadre de l'invention, la torche plasma est de préférence associée à un système de déplacement automatique situé perpendiculairement au sens de défilement du substrat revêtu et permettant le traitement de l'ensemble de la surface par aller-retour successif de la torche au dessus du substrat.

Le gaz insufflé est de préférence de l'azote, de l'air ou de l'argon, comprenant avantageusement une teneur volumique en hydrogène comprise entre 5 et 50%, notamment entre 15 et 30%.

Le chauffage de la couche mince peut également être réalisé en soumettant ladite couche mince à l'action d'au moins une flamme.

Ce traitement de flammage est de préférence réalisé sur un banc de flammage situé perpendiculairement au sens de défilement du substrat. La longueur du dispositif de flammage est de préférence au moins égale à la largeur du substrat revêtu, ce qui permet aisément le traitement au défilé sans nécessiter de système de déplacement. Le gaz utilisé peut être un mélange d'un gaz oxydant, notamment choisi parmi l'air, l'oxygène ou leurs mélanges, et d'un gaz combustible, notamment choisi parmi le gaz naturel, le propane, le butane, voire l'acétylène ou l'hydrogène, ou leurs mélanges. L'oxygène est préféré comme gaz oxydant, en particulier en combinaison avec le gaz naturel (méthane) ou le propane, d'une part car il permet d'atteindre des températures plus élevées et par conséquent de raccourcir le traitement et d'éviter la chauffe du substrat, et d'autre part car il permet d'éviter la création d'oxydes d'azote $NO_x$. Pour atteindre les températures souhaitées au niveau de la couche mince, le substrat revêtu est généralement positionné au sein de la flamme visible, notamment au niveau de la zone la plus chaude de la flamme, une partie de la flamme visible s'étendant alors autour de la zone traitée.

Le flammage est une technique couramment employée pour le traitement de la surface de polymères afin d'améliorer leurs propriétés de mouillabilité et faciliter leur revêtement par des peintures. Dans l'utilisation qui en est faite, le principe est de soumettre la surface à traiter à l'action de radicaux créés par la combustion, sans porter ladite surface à une température élevée. La demande US 2006/128563 décrit l'utilisation de cette technique pour activer des surfaces de couches d'oxyde de titane afin d'améliorer leurs propriétés d'hydrophilie. Les traitements décrits, assez similaires à ceux pratiqués sur les substrats polymères, consistent à faire défiler un substrat au niveau ou légèrement en-dessous (quelques centimètres) de la pointe de la flamme visible. Ce type de traitement, qui vise à créer des groupements hydroxyles à la surface de l'oxyde de titane, n'est toutefois pas propre à porter la couche mince d'oxyde de titane à des températures supérieures à 200°C et à augmenter le taux de cristallisation de l'oxyde de titane, car les températures au niveau de la pointe de la flamme visible sont insuffisantes.

Le chauffage de la couche mince peut encore être réalisé à l'aide d'un rayonnement dans le domaine des micro-ondes (longueurs d'onde allant de 1 millimètre à 30 centimètres, soit des fréquences allant de 1 à 300 GHz).

Le chauffage de la couche mince peut encore être réalisé en mettant ladite couche mince au contact d'un solide ou d'un liquide chaud. Il peut par exemple s'agir d'un rouleau chauffé mobile en rotation au contact duquel vient défiler le substrat revêtu de la couche mince à chauffer. Le rouleau peut être cylindrique ou comprendre une multiplicité de facettes, permettant ainsi d'augmenter la surface de contact entre le rouleau et le substrat. Le solide chaud, de préférence sous forme de rouleau, est de préférence réalisé en une matière souple afin de pouvoir se conformer à d'éventuelles irrégularités de surface ou déformations du substrat. Il possède de préférence une conductivité thermique élevée afin d'obtenir un bon transfert de chaleur à la surface du substrat. Le solide est de préférence porté à des températures d'au moins 500°C, voire 600°C et même 700°C.

Les modes de chauffage par induction et par flammage sont préférés lorsque l'on ne souhaite pas mettre en oeuvre de dispositif mécanique de déplacement au-dessus du substrat. Les modes de chauffage par rayonnement infrarouge ou induction peuvent quant à eux être mis en oeuvre au sein du dispositif de dépôt sous vide de la ligne magnétron. Ces derniers sont également avantageux lorsque l'on ne souhaite pas consommer de grandes quantités de gaz.

Lorsque la couche mince est à base d'oxyde de titane (ou est constituée d'oxyde de titane), un mode de réalisation préféré de l'invention consiste à porter ladite couche mince à une température comprise entre 300 et 800°C, de préférence entre 400 et 600°C, de manière à ce que ladite couche mince comporte de l'oxyde de titane sous forme anatase. Comme indiqué supra, une telle cristallisation permet d'accroître considérablement l'activité photocatalytique de l'oxyde de titane. Le chauffage de la couche est de préférence réalisé par l'une des techniques suivantes :

- par contact avec un solide chaud à une température supérieure ou égale à 400°C,
- par chauffage à l'aide d'une torche plasma,
- à l'aide d'un laser à $CO_2$ émettant un rayonnement dont la longueur d'onde est de l'ordre de 10 micromètres,
- en soumettant ladite couche mince à l'action d'au moins une flamme.

Le procédé selon l'invention est particulièrement avantageux dans le cas de l'oxyde de titane, car lorsqu'un substrat contenant des ions alcalins (par exemple un verre du type silico-sodo-calcique) est porté à une température élevée, lesdits ions ont tendance à diffuser dans la couche d'oxyde de titane en amoindrissant très sensiblement, voire en annulant, ses propriétés photocatalytiques. Pour cette raison, il est d'usage d'interposer entre la couche mince d'oxyde de titane et le substrat une couche barrière à la migration des alcalins, comme enseigné dans la demande EP-A-0 850 204, ou d'augmenter l'épaisseur de la couche d'oxyde de titane pour qu'au moins l'extrême surface de la couche ne soit pas contaminée, comme enseigné dans la demande EP-A-0 966 409. Dans le cas du procédé selon l'invention, le substrat n'est presque pas chauffé et la migration des alcalins est par conséquent quasiment nulle. Le procédé selon l'invention permet donc d'obtenir des substrats en verre silico-sodo-calcique revêtus directement d'une fine couche d'oxyde de titane (par exemple de l'ordre de 10 nanomètres d'épaisseur) et présentant néanmoins une très forte activité photocatalytique.

Lorsque la couche mince est à base d'argent (ou est constituée d'argent), on porte de préférence ladite couche mince à une température comprise entre 300 et 600°C, préférentiellement entre 350 et 550°C. Les techniques préférées sont le chauffage à l'aide d'un laser émettant un rayonnement infrarouge, par induction, par torche plasma ou par flammage.

Il a été observé dans le cas des couches à base d'argent qu'un chauffage trop long ou de trop forte intensité, notamment à l'aide d'un laser émettant dans l'infrarouge ou par induction, pouvait non seulement conduire à une élévation de température du substrat, mais aussi détruire la continuité de la couche en créant à partir d'une couche initialement continue une couche discontinue comprenant des nodules d'argent isolés, produisant un flou par observation directe ou sous illumination forte. Ce mode de réalisation n'est évidemment pas souhaitable et n'est pas inclus dans la portée de l'invention.

L'invention a également pour objet un procédé d'obtention d'un matériau comprenant un substrat et au moins une couche mince, caractérisé en ce que l'on dépose ladite au moins une couche mince sur ledit substrat par pulvérisation cathodique assistée par champ magnétique, et en ce que l'on soumet ladite au moins une couche mince à un traitement thermique selon l'invention.

L'invention a encore pour objet les matériaux susceptibles d'être obtenus par le procédé selon l'invention.

Le procédé selon l'invention permet en effet d'obtenir des matériaux comprenant une couche mince dont le taux de cristallisation ne pouvait être obtenu que par des traitements thermiques de trempe, de bombage ou de recuit, soit des traitements affectant l'ensemble du substrat lors du dépôt. Les matériaux obtenus selon l'invention se différencient donc des matériaux connus de l'art antérieur par une structure différente, notamment par le fait qu'ils ne présentent pas dans leur épaisseur un profil de contraintes caractéristique de celui d'un verre trempé et/ou qu'ils ne donnent pas lieu à la même diffusion d'éléments (alcalins, oxygène etc.) en provenance du substrat ou de l'extérieur.

Un tel matériau est par exemple constitué d'un substrat en verre non-trempé, revêtu d'un empilement de couches minces comprenant au moins une couche d'argent d'épaisseur e (exprimée en nm). L'empilement se caractérise par une résistance carrée $R_c$ (exprimée en ohm) répondant à la formule :

$$R_c \times e^2 - 120 < 25 \times e.$$

La résistance par carré d'un film mince conducteur dépend de son épaisseur selon la loi de Fuchs-Sondheimer qui s'exprime R$_c$ x e$^2$ = ρ x e + A. Dans cette formule p désigne la résistivité intrinsèque du matériau formant la couche mince et A correspond à la réflexion spéculaire ou diffuse des porteurs de charges au niveau des interfaces. L'invention permet d'obtenir une amélioration de la résistivité intrinsèque p telle que p est inférieure ou égale à 25 et une amélioration de la réflexion des porteurs telle que A est inférieure ou égale à 120, de préférence 110 et même 105.

Le procédé selon l'invention permet ainsi d'obtenir des couches présentant de très faibles résistivités, qui n'avaient pu jusque-là être obtenues qu'à l'aide d'une trempe. Le verre n'étant pas trempé, ne présente toutefois pas dans son épaisseur le profil de contraintes caractéristique d'un verre trempé (présence de contraintes d'extension au coeur du verre et de compression au niveau des deux faces), et est pas conséquent découpable.

L'empilement est de préférence du type précédemment décrit dans le présent texte, ou dans les demandes WO2007/110552, WO2007/101964, WO2007/101963, WO2007/054656, WO2007/054655, WO2007/042688, WO2007/042687, WO2005/110939, WO2005/051858, WO2005/019126, WO04/043871, WO00/24686, WO00/29347, EP0995724, EP0995725 WO99/45415, EP922681, EP894774, EP877006, EP745569, EP718250 incorporées par référence.

Un matériau selon l'invention est encore constitué d'un substrat en verre du type silico-sodo-calcique, revêtu d'au moins une couche mince comprenant de l'oxyde de titane (et notamment constituée d'oxyde de titane) au moins partiellement cristallisé sous forme anatase, susceptible d'être obtenu par le procédé selon l'invention. Ce matériau se distingue des substrats revêtus par une couche d'oxyde de titane déposée par procédé magnétron sur un substrat chaud et/ou recuites dans un four, en ce que la couche d'oxyde de titane (ou d'éventuelles sous-couches) comprend moins d'oxyde de sodium provenant du substrat. Le procédé ne mettant pas en oeuvre de chauffage substantiel du substrat, les ions sodium ont en effet très nettement moins tendance à diffuser dans la couche à base d'oxyde de titane. La couche à base d'oxyde de titane est de préférence déposée directement sur le substrat, sans couche intermédiaire. Elle peut également être déposée sur des couches intermédiaires n'ayant pas de propriétés de barrière à la diffusion des ions alcalins, mais présentant des propriétés désirables (propriétés optiques par exemple). Le substrat en verre est de préférence non-trempé.

Un matériau selon l'invention est encore constitué d'un substrat revêtu d'au moins une couche mince transparente conductrice à base d'oxydes mixtes d'indium et de zinc ou d'étain, d'oxyde de zinc dopé à l'aluminium ou au gallium, à base d'oxyde de titane dopé au niobium, à base de stannate de cadmium et/ou de zinc, à base d'oxyde d'étain dopé au fluor et/ou à l'antimoine.

En particulier, un matériau particulièrement intéressant, qui n'a pu être obtenu par les techniques jusqu'alors connues, consiste en un substrat en verre non-trempé, revêtu d'au moins une couche à base d'oxyde de zinc dopé à l'aluminium ou au gallium. Ce matériau est caractérisé en ce que la rugosité de la couche à base d'oxyde de zinc dopé à l'aluminium ou au gallium présente une rugosité RMS inférieure ou égale à 10 nm et une résistance carrée inférieure ou égale à 15 ohms. La rugosité RMS est calculée à partir d'une mesure par AFM (microscopie à force atomique) réalisée sur un échantillon d'un micron carré. La rugosité RMS est même de préférence inférieure ou égale à 9 nm, voire 8 nm, et même 6 nm ou 5 nm.

De telles couches aussi peu résistives (dont l'épaisseur est assez élevée, parfois supérieure ou égale à 500 nm) et pourtant aussi peu rugueuses n'ont pu jusqu'alors être obtenues que par un traitement de trempe. A l'inverse, des couches aussi peu résistives ont pu être obtenues sur verre non trempé par un dépôt de type magnétron effectué sur substrat chauffé, mais dans ce cas les rugosités obtenues étaient beaucoup plus élevées.

Les couches des différents matériaux qui viennent d'être décrits peuvent bien évidemment présenter l'une quelconque des caractéristiques décrites dans l'ensemble du texte, seule ou en combinaison avec d'autres caractéristiques qui y sont également décrites.

Les substrats obtenus selon l'invention peuvent être utilisés dans des vitrages simples, multiples ou feuilletés, des miroirs, des revêtements muraux en verre. Dans le cas d'un vitrage multiple comportant au moins deux feuilles de verre séparées par une lame de gaz, il est préférable que la couche mince soit disposée sur la face en contact avec ladite lame de gaz. Ils peuvent également être utilisés dans des vitrages photovoltaïques ou des panneaux solaires, la couche mince traitée selon l'invention étant par exemple une électrode supérieure à base de ZnO : Al ou Ga dans des empilements à base de chalcopyrites (notamment du type CIS - CuInSe$_2$) ou à base de silicium amorphe et/ou polycristallin, ou encore à base de CdTe. Ils peuvent aussi être utilisés dans des écrans de visualisation du type LCD (Liquid Crystal Display), OLED (Organic Light Emitting Diodes) ou FED (Field Emission Display), la couche mince traitée selon l'invention étant par exemple une couche électroconductrice en ITO. Ils peuvent encore être utilisés dans des vitrages électrochromes, la couche mince traitée selon l'invention étant par exemple une couche électroconductrice transparente supérieure, comme enseignée dans la demande FR-A-2 833 107.

Des objets de l'invention sont définis par les clauses qui suivent.

1. Procédé de traitement d'au moins une couche mince continue déposée sur une première face d'un substrat, caractérisé en ce que l'on porte chaque point de ladite au moins une couche mince à une température d'au moins 300°C en maintenant une température inférieure ou égale à 150°C en tout point de la face dudit substrat opposée à ladite première face, de manière à augmenter le taux de cristallisation de ladite couche mince en la conservant continue et sans étape de fusion de ladite couche mince.

2. Procédé selon la clause 1, tel que le substrat est en verre, notamment silico-sodo-calcique.

3. Procédé selon l'une des clauses précédentes, tel que l'on maintient une température inférieure ou égale à 100°C, notamment 50°C, en tout point de la face du substrat opposée à la face sur laquelle est déposée la couche mince.

4. Procédé selon l'une des clauses précédentes, tel que chaque point de la couche mince est porté à une température supérieure ou égale à 300°C pour une durée inférieure ou égale à 1 seconde, voire 0,5 seconde.

5. Procédé selon l'une des clauses précédentes, tel que le taux de cristallisation obtenu est supérieur ou égal à 20 %, notamment 50%.

6. Procédé selon l'une des clauses précédentes, tel que le substrat présente au moins une dimension supérieure ou égale à 1 m, voire 2 m.

7. Procédé selon l'une des clauses précédentes, tel que la couche mince est à base d'un métal, oxyde, nitrure, ou mélange d'oxydes choisi parmi l'argent, le molybdène, le niobium, l'oxyde de titane, les oxydes mixtes d'indium et de zinc ou d'étain, l'oxyde de zinc dopé à l'aluminium ou au gallium, les nitrures de titane, d'aluminium ou de zirconium, l'oxyde de titane dopé au niobium, le stannate de cadmium et/ou de zinc, l'oxyde d'étain dopé au fluor et/ou à l'antimoine.

8. Procédé selon l'une des clauses précédentes, tel que la couche mince avant traitement ne contient pas de solvant aqueux ou organique, notamment est obtenue par pulvérisation cathodique.

9. Procédé selon l'une des clauses précédentes, tel que la couche mince est électroconductrice, et le chauffage de la couche mince est réalisé par induction.

10. Procédé selon l'une des clauses 1 à 8, tel que la couche mince absorbe au moins une partie du rayonnement infrarouge, et le chauffage de la couche mince est réalisé à l'aide d'un rayonnement dont la longueur d'onde est comprise dans ladite partie du rayonnement infrarouge absorbée par ladite couche.

11. Procédé selon l'une des clauses 1 à 8, tel que le chauffage de la couche mince est réalisé par des techniques de projection thermique, notamment par une technique de projection par torche plasma.

12. Procédé selon l'une des clauses 1 à 8, tel que le chauffage de la couche mince est réalisé en soumettant ladite couche mince à l'action d'au moins une flamme.

13. Procédé selon l'une des clauses 1 à 8, tel que le chauffage de la couche mince est réalisé en mettant ladite couche mince au contact d'un solide chaud.

14. Procédé selon l'une des clauses 1 à 8 et 10 à 13, tel que, la couche mince étant à base d'oxyde de titane, on porte ladite couche mince à une température comprise entre 300 et 800°C de manière à ce que l'oxyde de titane soit majoritairement sous forme anatase.

15. Procédé selon l'une des clauses 1 à 13, tel que, la couche mince étant à base d'argent, on porte ladite couche mince à une température comprise entre 300 et 600°C, préférentiellement entre 350 et 550°C.

16. Procédé d'obtention d'un matériau comprenant un substrat et au moins une couche mince, caractérisé en ce que l'on dépose ladite au moins une couche mince sur ledit substrat par pulvérisation cathodique assistée par champ magnétique, et en ce que l'on soumet ladite au moins une couche mince au procédé selon l'une des clauses précédentes 1 à 15.

17. Matériau susceptible d'être obtenu par le procédé selon l'une des clauses précédentes.

18. Matériau, notamment selon la clause 17, qui est un substrat en verre non-trempé revêtu d'un empilement de couches minces comprenant au moins une couche d'argent d'épaisseur e (exprimée en nm), caractérisé en ce que l'empilement présente une résistance carrée $R_c$ (exprimée en ohm) répondant à la formule :

$$R_c \times e^2 - 120 < 25 \times e$$

19. Matériau selon la clause 17, qui est un substrat en verre du type silico-sodo-calcique revêtu d'au moins une couche mince comprenant de l'oxyde de titane au moins partiellement cristallisé sous forme anatase.

20. Matériau selon la clause 17, qui est un substrat revêtu d'au moins une couche mince transparente conductrice à base d'oxydes mixtes d'indium et de zinc ou d'étain ou d'oxyde de zinc dopé à l'aluminium ou au gallium.

21. Matériau, notamment selon la clause précédente, qui est un substrat en verre non-trempé, revêtu d'au moins une couche à base d'oxyde de zinc dopé à l'aluminium ou au gallium, caractérisé en ce que la rugosité de ladite couche à base d'oxyde de zinc dopé à l'aluminium ou au gallium présente une rugosité RMS inférieure ou égale à 10 nm et une résistance carrée inférieure ou égale à 15 ohms.

22. Utilisation du matériau selon les clauses de matériau précédentes dans des vitrages simples, multiples ou feuilletés, des miroirs, des revêtements muraux en verre, des vitrages photovoltaïques ou des panneaux solaires, dans des écrans de visualisation du type LCD (Liquid Crystal Display), OLED (Organic Light Emitting Diodes) ou FED (Field Emission Display), ou dans des vitrages électrochromes.

L'invention est illustrée à l'aide des exemples de réalisation non limitatifs qui suivent.

EXEMPLE 1

Un substrat en verre silico-sodo-calcique obtenu par le procédé float puis découpé de manière à ce que sa taille soit de 3 m de largeur pour 6 m de longueur est revêtu de manière connue par le procédé magnétron d'une couche mince d'oxyde de titane de 10 nm d'épaisseur. Dans un premier exemple, une couche de silice de 20 nm d'épaisseur est interposée entre le substrat et la couche d'oxyde de titane (échantillon A). Dans un second exemple, la couche d'oxyde de titane est déposée directement sur le substrat (échantillon B).
Entre la sortie de la ligne magnétron et le dispositif de stockage, on insère un dispositif comprenant :

- un laser $CO_2$ émettant un rayonnement à 10,6 micromètre de longueur d'onde focalisé sur la couche de $TiO_2$, la largeur du spot étant d'environ 0,3 à 0,5 mm, et
- un système de déplacement rapide du laser (de l'ordre de 3 à 5 mètres/seconde) dans une direction perpendiculaire à la direction de défilement du substrat.

La température du substrat en verre au cours du traitement ne dépasse pas 50°C, mesurée par pyrométrie au niveau de la face du substrat opposée à la face portant le revêtement de couches minces.
Le tableau 1 ci-après indique l'activité photocatalytique de la couche avant traitement et suite au traitement.
L'activité photocatalytique correspond à une mesure de vitesse de dégradation de bleu de méthylène en présence de rayonnement ultraviolet. Une solution aqueuse de bleu de méthylène est placée en contact dans une cellule étanche avec le substrat revêtu (ce dernier formant le fond de la cellule). Après exposition à un rayonnement ultraviolet pendant 30 minutes, la concentration de bleu de méthylène est évaluée par une mesure de transmission lumineuse. La valeur d'activité photocatalytique (notée Kb et exprimée en $g.l^{-1}.min^{-1}$), correspond à la diminution de la concentration en bleu de méthylène par unité de temps d'exposition.

**Tableau 1**

| Echantillon | Kb, avant traitement | Kb, après traitement |
|---|---|---|
| A | <7 | 25 |
| B | <7 | 23 |

L'augmentation importante de l'activité photocatalytique après traitement selon l'invention illustre l'amélioration de la cristallinité de la couche d'oxyde de titane. La similitude des valeurs obtenues selon qu'une sous-couche est interposée ou non entre le substrat et la couche d'oxyde de titane témoigne du fait que le faible échauffement du substrat ne génère pas de diffusion significative des ions alcalins dans la couche d'oxyde de titane. Le traitement selon l'invention permet donc de rendre inutile la sous-couche barrière à la diffusion des ions alcalins.

EXEMPLE 2

Un substrat en verre silico-sodo-calcique obtenu par le procédé float puis découpé de manière à ce que sa taille soit de 3 m de largeur pour 6 m de longueur est revêtu de manière connue par le procédé magnétron d'un empilement de couches minces comprenant une couche d'argent, ladite couche d'argent conférant des propriétés de basse émissivité au verre.
Cet empilement comprend dans l'ordre (depuis le substrat jusqu'à la surface extérieure) les couches d'oxydes, métalliques ou de nitrures suivantes, les épaisseurs géométriques étant indiquées entre parenthèses :

Verre / $SnO_2$ (20 nm) / ZnO (15 nm) /Ag (8,5 nm) / Ni-Cr / ZnO (15 nm) / $Si_3N_4$ (25 nm).

Entre la sortie de la ligne magnétron et le dispositif de stockage, on insère un dispositif comprenant :

- un laser YAG (grenat d'aluminium et d'yttrium $Y_2Al_{15}O_2$) dopé au néodyme, émettant, en mode continu ou pulsé, un rayonnement à 1,09 micromètre de longueur d'onde focalisé sur la couche d'argent, la largeur du spot étant d'environ 0,3 à 0,5 mm, et
- un système de déplacement rapide du laser (de l'ordre de 3 à 5 mètres/seconde) dans une direction perpendiculaire à la direction de défilement du substrat.

La température du substrat en verre au cours du traitement ne dépasse pas 50°C, mesurée par pyrométrie au niveau de la face du substrat opposée à la face portant le revêtement de couches minces.

Le tableau 2 ci-après indique la variation suite au traitement des propriétés suivantes :

- la transmission lumineuse sous illuminant D65, calculée à partir d'un spectre expérimental, en prenant en référence l'illuminant standard D65 et l'observateur de référence « CIE 1964 », pour un double vitrage dont les feuilles de verre ont une épaisseur de 4 mm et la lame de gaz (mélange de 90% d'argon et de 10% d'air) présente une épaisseur de 16 mm, transmission notée « TL » et exprimée en pourcents,
- la résistance carrée, notée $R_c$ et exprimée en ohms,
- l'émissivité normale à la température de 283 K calculée selon la norme EN 12898 à partir d'un spectre en réflexion dans la gamme spectrale 5 - 50 micromètres, notée $\varepsilon_n$, et exprimée en pourcents.

Ces deux dernières propriétés (résistance carrée et émissivité), qui illustrent les performances de conductivité électrique et de basse-émissivité de la couche, reflètent le taux de cristallisation et la taille des cristaux de la couche d'argent car des couches d'argent mieux cristallisées présentent à la fois une conductivité électrique plus élevée et de meilleures propriétés d'émissivité.

**Tableau 2**

| TL (%) | | $R_c$ ($\Omega$) | | $\varepsilon_n$ (%) | |
|---|---|---|---|---|---|
| avant | après | avant | après | avant | après |
| 77,0 | 78,3 | 5,0 | 4,5 | 5,5 | 5,0 |

Les variations dues au traitement en terme de résistance carrée et d'émissivité normale sont de l'ordre de 10%. Ces résultats montrent que le traitement de l'empilement (et notamment le traitement de la couche d'argent) à l'aide du laser infrarouge a eu pour conséquence une amélioration de la cristallisation de la couche d'argent, caractérisée en particulier par un taux de cristallisation plus fort et une taille de cristaux plus grande. On peut en outre noter une augmentation significative de la transmission lumineuse du vitrage obtenu.

EXEMPLE 3

On utilise dans cet exemple un substrat revêtu identique à celui de l'exemple 2, donc revêtu par un empilement comprenant une couche d'argent.
Le procédé de chauffage est l'induction, réalisée à l'aide d'un inducteur dont la géométrie est spécifiquement adaptée au traitement de surfaces planes. La fréquence est de 2 MHz, la puissance pouvant varier autour de quelques kW.
La température du substrat en verre au cours du traitement, lequel ne dure que quelques secondes, ne dépasse pas 150°C.
Le tableau 3 ci-après indique la variation des propriétés décrites dans le cas de l'exemple 2.

**Tableau 3**

| TL (%) | | $R_c$ ($\Omega$) | | $\varepsilon_n$ (%) | |
|---|---|---|---|---|---|
| avant | après | avant | après | avant | après |
| 76,9 | 77,5 | 5,0 | 4,6 | 5,5 | 5,1 |

Les variations de résistance carrée et d'émissivité, assez comparables avec celles induites par le traitement au laser infrarouge témoignent encore d'une augmentation du taux de cristallisation de la couche d'argent.

EXEMPLE 4

On utilise dans cet exemple des substrats revêtus identiques à ceux de l'exemple 1, donc revêtus par un empilement comprenant une couche d'oxyde de titane.
Le procédé de chauffage employé est le contact avec une surface plane chauffée à 700°C pendant 1 seconde. La température du verre (côté opposé à la couche) ne dépasse pas 150°C durant le traitement.

Le tableau 4 ci-après indique l'activité photocatalytique avant et après traitement.

**Tableau 4**

| Echantillon | Kb, avant traitement | Kb, après traitement |
|---|---|---|
| A | <7 | 22 |
| B | <7 | 23 |

Les valeurs obtenues sont similaires à celles obtenues selon l'exemple 1.

EXEMPLE 5

Un substrat identique à celui traité selon les exemples 2 et 3 subit dans le cadre de cet exemple un chauffage réalisé à l'aide d'une torche plasma. Le gaz plasmagène est un mélange d'argon ou d'azote avec de l'hydrogène dans un rapport 4 :1.
La torche plasma, de puissance 25 à 40 kW, est montée sur un dispositif de déplacement rapide (de l'ordre de 1 à 4 mètres/seconde) dans une direction perpendiculaire à la direction de défilement du substrat. La largeur de la zone affectée par la torche plasma est d'environ 3 à 10 mm.
La température du substrat en verre au cours du traitement ne dépasse pas 90°C.
Le tableau 5 ci-après présente les variations dues au chauffage en terme de transmission lumineuse, de résistance carrée et d'émissivité normale.

**Tableau 5**

| TL (%) | | $R_c$ ($\Omega$) | | $\varepsilon_n$ (%) | |
|---|---|---|---|---|---|
| avant | après | avant | après | avant | après |
| 77,0 | 78,5 | 5,0 | 4,4 | 5,5 | 4,9 |

Le tableau 6 ci-après détaille les mêmes propriétés, mais pour un empilement dans lequel la couche d'argent a une épaisseur de 15 nm.

**Tableau 6**

| TL (%) | | $R_c$ ($\Omega$) | | $\varepsilon_n$ (%) | |
|---|---|---|---|---|---|
| avant | après | avant | après | avant | après |
| 71,0 | 72,0 | 2,2 | 2,0 | 2,4 | 2,2 |

Comme dans le cas des exemples 2 et 3, le chauffage induit une amélioration des propriétés, signe d'une meilleure cristallisation de la couche d'argent.

EXEMPLE 6 :

On utilise dans cet exemple des substrats revêtus identiques à ceux des exemples 1 et 4, donc revêtus par un empilement comprenant une couche d'oxyde de titane.
Le dispositif de traitement par torche plasma est identique à celui décrit dans le cas de l'exemple 5. La température du substrat en verre au cours du traitement ne dépasse pas 90°C.
Le tableau 7 ci-après indique l'activité photocatalytique de la couche d'oxyde de titane avant et après traitement.

**Tableau 7**

| Echantillon | Kb, avant traitement | Kb, après traitement |
|---|---|---|
| A | <7 | 25 |
| B | <7 | 22 |

EXEMPLE 7

Le même substrat revêtu que celui traité dans les exemples 2, 3 et 5 subit dans le cadre de cet exemple un chauffage à l'aide de flammes. Le combustible est du propane, le comburant étant de l'air. L'oxygène permet également d'obtenir de bons résultats.

Le substrat revêtu, après dépôt au sein de l'enceinte de dépôt magnétron, est déplacé à vitesse constante sous un banc de flammage fixe dont la largeur est supérieure ou égale à la largeur du substrat, ce dernier défilant à une vitesse comprise entre 2 et 10 mètres/minute sous le banc. La couche à traiter est placée au niveau de la zone la plus chaude de la flamme.

La température du substrat en verre au cours du traitement ne dépasse toutefois pas 100°C.

Le tableau 8 ci-après montre également une évolution favorable de la cristallisation de la couche d'argent.

**Tableau 8**

| TL (%) | | $R_c$ ($\Omega$) | | $\varepsilon_n$ (%) | |
|---|---|---|---|---|---|
| avant | après | avant | après | avant | après |
| 77,0 | 78,2 | 5,1 | 4,5 | 5,6 | 5,0 |

EXEMPLE 8 :

On utilise dans cet exemple des substrats revêtus identiques à ceux des exemples 1, 4 et 6, donc revêtu par un empilement comprenant une couche d'oxyde de titane.

Le traitement est similaire à celui subi dans le cas de l'exemple 7 (traitement par flammage). La température du verre (côté oppose à la couche) ne dépasse pas 150°C.

Le tableau 9 ci-après indique les valeurs d'activité photocatalytique avant et après traitement.

**Tableau 9**

| Echantillon | Kb, avant traitement | Kb, après traitement |
|---|---|---|
| A | <7 | 20 |
| B | <7 | 18 |

EXEMPLE 9 :

Une couche d'oxyde mixte d'indium et d'étain (ITO) d'épaisseur 500 nm est déposée sur un substrat en verre de manière connue par procédé magnétron.

Sa résistance carrée est de 20 $\Omega$, ce qui témoigne d'un caractère très majoritairement amorphe de la couche.

Le traitement est similaire à celui subi dans le cas de l'exemple 7 (traitement par flammage), la température du verre (côté oppose à la couche) ne dépassant pas 150°C.

Après traitement, la résistance carrée de la couche est 4 $\Omega$, signe d'une amélioration notable de son taux de cristallisation.

EXEMPLE 10 :

Une couche transparente conductrice à base d'oxyde de zinc dopé avec de l'aluminium de 200 nm d'épaisseur est déposée sur un substrat en verre par un procédé magnétron.

Le traitement subi est similaire à celui de l'exemple 5 (torche plasma).

Le tableau 10 ci-après indique les valeurs de résistance carrée, d'absorption lumineuse, de mobilité électronique et de densité électronique (ces deux dernières étant mesurées par effet Hall) avant et après traitement.

**Tableau 10**

| Absorption (%) | | $R_c$ ($\Omega$) | | Densité électronique ($\times 10^{20}$.cm$^{-3}$) | | Mobilité (cm$^2$/V.s) | |
|---|---|---|---|---|---|---|---|
| avant | après | avant | après | avant | après | avant | après |
| 8,5 | 3,2 | 106 | 35 | 1,3 | 2,6 | 18 | 28 |

Le procédé selon l'invention permet donc d'améliorer considérablement les propriétés de conduction électronique grâce à l'amélioration de la cristallisation de la couche : cette dernière permet en effet non seulement d'augmenter la mobilité des électrons par la diminution des joints de grains, mais aussi la densité de porteurs par la diminution de défauts cristallins. La résistivité après traitement est ainsi divisée par un facteur allant de 2 à 3.

La rugosité RMS de la couche après traitement est de 3 nm, calculée à partir d'une mesure AFM réalisée sur un échantillon d'un micron carré.

Dans le cas d'un traitement réalisé sur un empilement comprenant, en plus de la couche de ZnO dopé, une sous-couche et une surcouche de protection, l'amélioration est moindre (environ 35%).

EXEMPLE 11 :

Une couche transparente conductrice à base d'oxyde de zinc dopé avec de l'aluminium de 180 nm d'épaisseur est déposée sur un substrat en verre par un procédé magnétron.

Le traitement subi est similaire à celui de l'exemple 7 (flammage).

Le tableau 11 ci-après indique les valeurs de résistance carrée et de transmission lumineuse avant et après traitement.

**Tableau 11**

| Transmission (%) | | $R_c$ $(\Omega)$ | |
|---|---|---|---|
| avant | après | avant | après |
| 72,5 | 75,0 | 120 | 60 |

La rugosité RMS de la couche après traitement est de 3 nm, calculée à partir d'une mesure AFM réalisée sur un échantillon d'un micron carré.

Le même type de traitement a été effectué sur une couche d'oxyde de zinc dopé avec de l'aluminium de 750 nm d'épaisseur. La résistance carrée est passée de 26 ohms (avant traitement) à 9,7 ohms (après traitement), pour une rugosité RMS comprise entre 3 et 5 nm.

EXEMPLE 12 :

Une couche transparente conductrice à base d'oxyde de zinc dopé avec de l'aluminium (épaisseur 190 nm) est déposée sur un substrat en verre par un procédé magnétron.

Le traitement subi est similaire à celui de l'exemple 1 (traitement au laser $CO_2$).

Le tableau 12 ci-après indique les valeurs de résistance carrée et de transmission lumineuse avant et après traitement.

**Tableau 12**

| Transmission (%) | | $R_c$ $(\Omega)$ | |
|---|---|---|---|
| avant | après | avant | après |
| 74,4 | 78,3 | 94,8 | 40,5 |

La rugosité RMS de la couche après traitement est de 3 nm, calculée à partir d'une mesure AFM réalisée sur un échantillon d'un micron carré.

EXEMPLE 13 (comparatif)

Un substrat revêtu d'un empilement comprenant une couche d'argent déjà décrit aux exemples 2, 3, 5 et 7, mais dans lequel l'épaisseur de la couche d'argent est de 9 nm, est déplacé après le dépôt sous une série de lampes émettant un rayonnement infrarouge et chauffant sans discernement la couche comme le substrat.

La puissance de la lampe était d'environ 150 kW/m² et la longueur d'ondes du rayonnement émis comprise entre 1 et 3 micromètres.

Le tableau 13 ci-après montre que le chauffage à l'aide des lampes améliore sensiblement la cristallisation des couches d'argent.

La température du substrat au niveau de la face opposée à la face portant l'empilement de couche a toutefois dépassé 300°C pendant le traitement, engendrant une casse de la majorité des feuilles de verre traitées.

**Tableau 13**

| TL (%) | | $R_c$ ($\Omega$) | | $\varepsilon_n$ (%) | |
|---|---|---|---|---|---|
| avant | après | avant | après | avant | après |
| 77,2 | 78,5 | 4,6 | 3,8 | 5,1 | 4,3 |

EXEMPLE 14 : (comparatif)

On utilise dans cet exemple des substrats revêtus identiques à ceux de l'exemple 1, donc revêtus par des empilements comprenant une couche de $TiO_2$.

Le traitement est réalisé en déplaçant le substrat après le dépôt sous une série de lampes émettant un rayonnement infrarouge et chauffant sans discernement la couche comme le substrat.

La puissance de la lampe était d'environ 150 kW/m$^2$ et la longueur d'ondes du rayonnement émis comprise entre 1 et 3 micromètres. Seule une faible partie du rayonnement est absorbée par le substrat et la couche.

Le tableau 14 ci-après montre que le chauffage à l'aide des lampes permet d'améliorer l'activité photocatalytique des couches $TiO_2$.

**Tableau 14**

| Echantillon | Kb, avant traitement | Kb, après traitement |
|---|---|---|
| A | <7 | 25 |
| B | <7 | <10 |

Pour des temps de chauffage de 2 à 3 minutes, la température du substrat au niveau de la face opposée à la face portant l'empilement de couche a toutefois dépassé 300°C pendant le traitement, engendrant une casse de la majorité des feuilles de verre traitées.

Le chauffage important du substrat provoque en outre la diffusion du sodium dans la couche, diminuant considérablement l'activité photocatalytique lorsqu'aucune sous-couche n'est employée (cas de l'exemple B).

## Revendications

**1.** Matériau qui est un substrat en verre non-trempé revêtu sur sa première face d'un empilement de couches minces comprenant au moins une couche d'argent d'épaisseur e (exprimée en nm), susceptible d'être obtenu par un procédé de traitement dans lequel on porte chaque point de ladite au moins une couche mince d'argent à une température d'au moins 300°C en maintenant une température inférieure ou égale à 150°C en tout point de la face dudit substrat opposée à ladite première face, de manière à augmenter le taux de cristallisation de ladite couche mince d'argent en la conservant continue et sans étape de fusion de ladite couche mince d'argent, ledit matériau étant tel que l'empilement présente une résistance carrée $R_c$ (exprimée en ohm) répondant à la formule :

$$R_c \times e^2 - 120 < 25 \times e.$$

**2.** Matériau selon la revendication précédente, tel que l'empilement présente une résistance carrée $R_c$ (exprimée en ohm) répondant à la formule :

$$R_c \times e^2 - 110 < 25 \times e.$$

**3.** Matériau selon la revendication précédente, tel que l'empilement présente une résistance carrée $R_c$ (exprimée en ohm) répondant à la formule :

$$R_c \times e^2 - 105 < 25 \times e.$$

**4.** Matériau selon l'une des revendications précédentes, tel que le substrat présente au moins une dimension supérieure ou égale à 1 m, voire 2 m.

**5.** Matériau selon l'une des revendications précédentes, tel que le substrat est transparent.

**6.** Matériau selon l'une des revendications précédentes, tel que le substrat est en verre silico-sodo-calcique.

**7.** Matériau selon l'une des revendications précédentes, tel que la couche d'argent est disposée entre deux couches minces diélectriques à base d'oxyde ou de nitrure.

**8.** Matériau selon l'une des revendications précédentes, tel qu'une couche très fine destinée à favoriser le mouillage et la nucléation de l'argent, notamment en oxyde de zinc, est disposée sous la couche d'argent.

**9.** Matériau selon l'une des revendications précédentes, tel que l'empilement comprend plusieurs couches d'argent.

**10.** Matériau selon l'une des revendications précédentes, tel que ladite au moins une couche mince d'argent est déposée sur ledit substrat par pulvérisation cathodique assistée par champ magnétique.

**11.** Utilisation du matériau selon l'une des revendications précédentes dans des vitrages simples, multiples ou feuilletés.

Europäisches
Patentamt

European
Patent Office

Office européen
des brevets

# RAPPORT DE RECHERCHE EUROPEENNE

Numéro de la demande

EP 14 17 2252

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2004/005467 A1 (NEUMAN GEORGE [US] ET AL) 8 janvier 2004 (2004-01-08) * * <br> * page 7; tableau 5 * <br> * page 8; tableau 7 * <br> ----- | 1-11 | INV. <br> C03C17/09 <br> C03C17/245 <br> C03C17/36 <br> C03C23/00 <br> C30B1/08 <br> C23C14/58 <br> H01L31/0224 <br> H01L31/18 |

DOMAINES TECHNIQUES RECHERCHES (IPC)

C03C

Le présent rapport a été établi pour toutes les revendications

| Lieu de la recherche | Date d'achèvement de la recherche | Examinateur |
|---|---|---|
| La Haye | 16 septembre 2014 | Mertins, Frédéric |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 14 17 2252

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-09-2014

| Document brevet cité au rapport de recherche | Date de publication | Membre(s) de la famille de brevet(s) | Date de publication |
|---|---|---|---|
| US 2004005467 A1 | 08-01-2004 | CA 2518274 A1 | 14-10-2004 |
| | | EP 1606225 A2 | 21-12-2005 |
| | | PL 215878 B1 | 28-02-2014 |
| | | US 2004005467 A1 | 08-01-2004 |
| | | US 2005145480 A1 | 07-07-2005 |
| | | US 2006078746 A1 | 13-04-2006 |
| | | US 2010276274 A1 | 04-11-2010 |
| | | WO 2004087598 A2 | 14-10-2004 |

EPO FORM P0460

Pour tout renseignement concernant cette annexe : voir Journal Officiel de l'Office européen des brevets, No.12/82

**EP 2 792 650 A1**

**Documents brevets cités dans la description**

- WO 2007018951 A
- WO 0240417 A
- WO 2005040058 A
- US 2006128563 A
- EP 0850204 A
- EP 0966409 A
- WO 2007110552 A
- WO 2007101964 A
- WO 2007101963 A
- WO 2007054656 A
- WO 2007054655 A
- WO 2007042688 A
- WO 2007042687 A
- WO 2005110939 A
- WO 2005051858 A
- WO 2005019126 A
- WO 04043871 A
- WO 0024686 A
- WO 0029347 A
- EP 0995724 A
- EP 0995725 A
- WO 9945415 A
- EP 922681 A
- EP 894774 A
- EP 877006 A
- EP 745569 A
- EP 718250 A
- FR 2833107 A